Europäisches Patentamt

European Patent Office

Office européen des brevets

(19)

(11) Veröffentlichungsnummer: **0 281 787**
**A1**

## (12) EUROPÄISCHE PATENTANMELDUNG

(21) Anmeldenummer: 88102121.6

(22) Anmeldetag: 12.02.88

(51) Int. Cl.⁴: **G01N 24/04**

(30) Priorität: 25.02.87 DE 3706087

(43) Veröffentlichungstag der Anmeldung:
14.09.88 Patentblatt 88/37

(84) Benannte Vertragsstaaten:
DE GB

(71) Anmelder: **Siemens Aktiengesellschaft Berlin und München**
**Wittelsbacherplatz 2**
**D-8000 München 2(DE)**

(72) Erfinder: **Requardt, Hermann, Dr.**
**Hofmannstrasse 107**
**D-8520 Erlangen(DE)**

(54) Oberflächenresonator für Kernspin-Resonanzgeräte.

(57) Der Erfindung liegt die Aufgabe zugrunde, einen Oberflächenresonator so auszuführen, daß er vorteilhaft an eine Anpaßschaltung (20) angekoppelt werden kann.

Gemäß der Erfindung besteht der Oberflächenresonator aus mindestens zwei benachbart angeordneten Windungen (19a, 19b). Die Enden jeder Windung (19a,19b) sind über die Reihenschaltung von je zwei Kondensatoren (19c,19d;19e, 19f) miteinander verbunden. Jeweils die Verbindungspunkte der Kondensatoren (19c,19d;19e,19f) miteinander, die den elektrischen Symmetriepunkt jeder Windung (19a,19b) darstellen, sind mit Massepotential verbunden. Der Signalabgriff und die Signaleinspeisung für den Oberflächenresonator erfolgt galvanisch an den Enden einer Windung (19b).

Der erfindungsgemäße Oberflächenresonator läßt sich sowohl für die Bildgebung als auch für die Spektroskopie bei kernmagnetischen Untersuchungsgeräten einsetzen.

FIG 2

EP 0 281 787 A1

## Oberflächenresonator für Kernspinresonanz-Geräte

Die Erfindung betrifft einen Oberflächenresonator mit zwei benachbart angeordneten Windungen für Kernspinresonanz-Geräte.

Ein derartiger Oberflächenresonator ist bekannt aus dem Artikel "Counter rotating current local coils for high resolution magnetic resonance imaging" in "Magnetic Resonance in Medicine", 3, 1986, Seiten 590 bis 603. Dabei sind zwei Loop-Gap-Resonatoren benachbart angeordnet und elektrisch miteinander gekoppelt. Es sind zwei Resonanzfälle mit unterschiedlicher Resonanzfrequenz möglich, wobei in einem Fall die Ströme in den Loop-Gap-Resonatoren parallel und im anderen Fall antiparallel fliessen. Die Ankoppelung dieses Oberflächenresonators an das Kernspinresonanz-Gerät erfolgt mit einer im Inneren des Oberflächenresonators angeordneten Koppelspule.

Oberflächenresonatoren werden wie Oberflächenspulen eingesetzt, wenn ein lokal begrenzter Untersuchungsbereich mit erhöhter Auflösung erfaßt werden soll. Dabei ist ein Einsatz sowohl als Sender als auch als Empfänger für Bildgebung und Spektroskopie möglich. Bei allen Anwendungen stört jedoch die innerhalb des Oberflächenresonators angeordnete Koppelspule. Mit der Koppelspule kann keine vollkommene Symmetrie erreicht werden, so daß das Sende-und Empfangsfeld an Homogenität verliert. Mit der induktiven Ankoppelung sind Transformationsverluste verbunden. Im Falle der Bildgebung treten durch die Koppelspule Bildstörungen auf.

Aufgabe der Erfindung ist es daher, einen Oberflächenresonator der eingangs genannten Art so auszuführen, daß die genannten Nachteile vermieden werden.

Diese Aufgabe wird erfindungsgemäß dadurch gelöst, daß die Enden jeder Windung über die Reihenschaltung von je zwei Kondensatoren miteinander verbunden sind, daß jeweils die Verbindungspunkte der Kondensatoren miteinander, die den elektrischen Symmetriepunkt jeder Windung darstellen, mit Massepotential verbunden sind und daß Signalabgriff und Signaleinspeisung für den Oberflächenresonator galvanisch an den Enden einer Wicklung erfolgt.

Vorteilhafterweise kann jede Windung aus einem Band aus Kupferfolie bestehen.

Eine konstruktiv besonders einfache Unterbringung der Windungen wird möglich, wenn ein Träger aus einem zu einem Ring geformten Stab mit rechteckigem Querschnitt vorgesehen ist, wobei die beiden Windungen durch leitfähige Beläge auf zwei Seiten des Stabes gebildet werden.

Der Oberflächenresonator kann zur Untersuchung verschiedener Kerne mit unterschiedlichen Resonanzfrequenzen eingesetzt werden, wenn auf dem Stab auf vier Seiten Windungen in Form von leitfähigen Belägen aufgebracht sind, wobei je zwei Windungen zu einem Resonator zusammengeschaltet sind und die so gebildeten Resonatoren durch Einsatz von Kondensatoren mit unterschiedlicher Kapazität unterschiedliche Resonanzfrequenzen aufweisen.

Ein homogenes Empfindlichkeitsfeld des Oberflächenresonators erhält man, wenn zwei Oberflächenresonatoren in Helmholtzanordnung so angeordnet sind, daß alle Windungsachsen auf einer Linie liegen.

Die Erfindung wird nachfolgend anhand von Ausführungsbeispielen nach den FIG 1 bis 5 näher erläutert.

FIG 1 zeigt den prinzipiellen Aufbau eines Kernspinresonanz-Gerätes,

FIG 2 zeigt die prinzipielle Anordnung eines Oberflächenresonators,

FIG 3 zeigt einen auf einem Ring mit quadratischem Querschnitt aufgebauten Oberflächenresonator in Draufsicht,

FIG 4 zeigt denselben Oberflächenresonator im Querschnitt und

FIG 5 zeigt die Anordnung zweier Oberflächenresonatoren an einem Stativ.

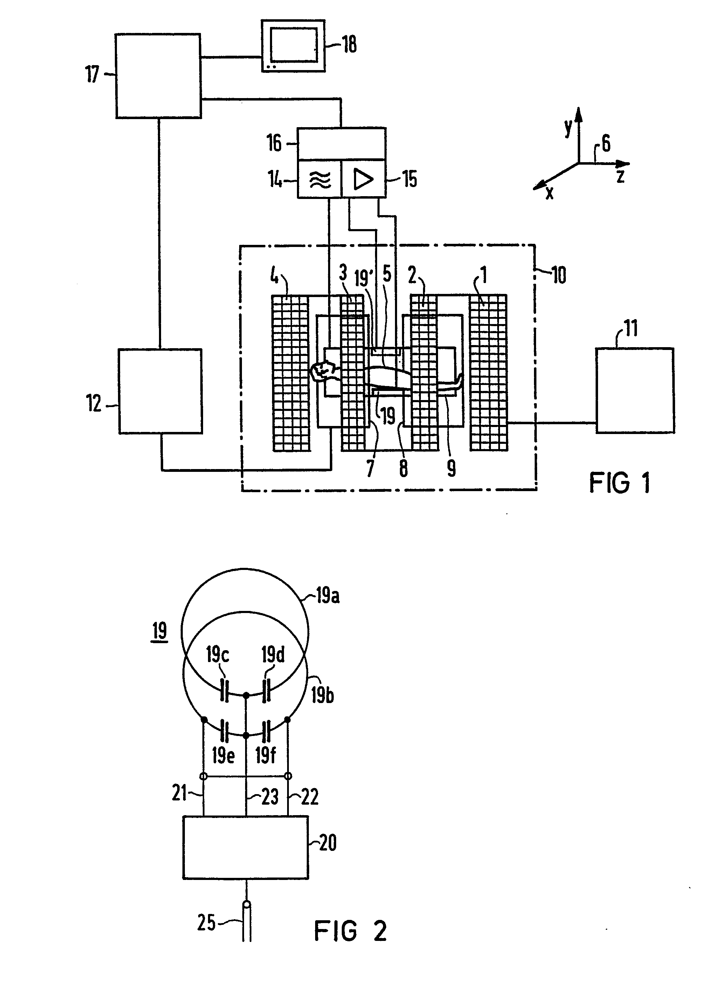

FIG 1 zeigt schematisch den prinzipiellen Aufbau eines Kernspin-Resonanzgerätes zur Ermittlung von Spektren eines Untersuchungsgerätes. Mit 1 und 2 sowie 3 und 4 sind Spulen bezeichnet, die ein magnetisches Grundfeld $B_0$ erzeugen, in welchem sich bei medizinischer Anwendung der zu untersuchende Körper 5 eines Patienten befindet. Diesem sind außerdem Gradientenspulen zugeordnet, die zur Erzeugung unabhängiger, zueinander senkrechter Magnetfeldgradienten der Richtungen x,y und z gemäß dem Koordinatenkreuz 6 vorgesehen sind. In der Figur sind der Übersichtlichkeit halber nur die Gradientenspulen 7 und 8 gezeichnet, die zusammen mit einem Paar gegenüberliegender, gleichartiger Gradientenspulen zur Erzeugung eines Gradienten in x-Richtung dienen. Die gleichartigen, nicht gezeichneten Gradientenspulen, zur Erzeugung eines Gradienten in y-Richtung liegen parallel zum Körper 5 und oberhalb sowie unterhalb von ihm, die für das Gradientenfeld in z-Richtung quer zu seiner Längesachse am Fuß-und am Kopfende. Die Anordnung enthält außerdem noch einen zur Erzeugung der Kernresonanzsignale dienenden Körper-Resonator 9 als Antenne. Zur Aufnahme der Kernresonanzsignale sind Oberflächenresonatoren 19,19′ auf der Oberseite

und auf der Unterseite des Körpers 5 vorgesehen.

Die von einer strichpunktierten Linie 10 umgrenzten Spulen 1, 2,3,4,7,8 und 9 stellen das eigentliche Untersuchungsinstrument dar. Es wird von einer elektrischen Anordnung aus betrieben, die ein Netzgerät 11 zum Betrieb der Spulen 1 bis 4 sowie eine Gradientenstromversorgung 12, an welcher die Gradientenspulen 7 und 8 sowie die weiteren Gradientenspulen anliegen, umfaßt. Ein von einem Prozeßrechner 17 gesteuerter Hochfrequenzsender 14 ist mit dem Ganzkörperresonator 9 verbunden. Die Oberflächenresonatoren 19,19' sind über einen Signalverstärker 15 ebenfalls an den Prozeßrechner 17 gekoppelt, an den zur Ausgabe eines Spektrums ein Bildschirmgerät 18 angeschlossen ist. Die Komponenten 14 und 15 bilden eine Hochfrequenzeinrichtung 16 zur Signalerzeugung und -aufnahme.

Bei dem in FIG 2 dargestellten schematischen Aufbau des Oberflächenresonators sind zwei Windungen 19a und 19b benachbart angeordnet. Die Enden jeder Windung 19a und 19b sind über die Reihenschaltung je zweier Kondensatoren 19c,19d bzw.19e,19f miteinander verbunden. Die Mittelabgriffe der Kondensatoren 19c, 19d und 19e,19f, die den elektrischen Symmetriepunkt und damit die virtuelle Masse der jeweiligen Windung darstellen, sind mit einem Massepotential in einer Anpaßschaltung 20 verbunden.

Die Signaleinspeisung auf den Oberflächenresonator erfolgt von der Anpaßschaltung 20 über abgeschirmte Leitungen 21 und 22 auf die mit den Kondensatoren 1e bzw.1f verbundenen Enden der Windung 19b. Damit ist die Anpaßschaltung 20 an die Windung 19b direkt galvanisch angekoppelt, die Ankopplung an die Windung 19a erfolgt dann induktiv. Das dargestellte Gebilde ist elektrisch schwingungsfähig, wobei die Resonanzfrequenz durch die Windung 19a und 19b sowie die Kapazitäten der Kondensatoren 19c,19d,19e und 19f bestimmt wird.

Durch diese Art der Ankopplung wird eine gute elektrische Symmetrie erreicht und damit das Sendefeld bzw. Empfangsfeld homogen. Durch die galvanische Ankopplung werden Transformationsverluste vermieden. Schließlich treten keine Bildstörungen auf, wie sie bei bekannten Oberflächenresonatoren durch Koppelspulen verursacht werden.

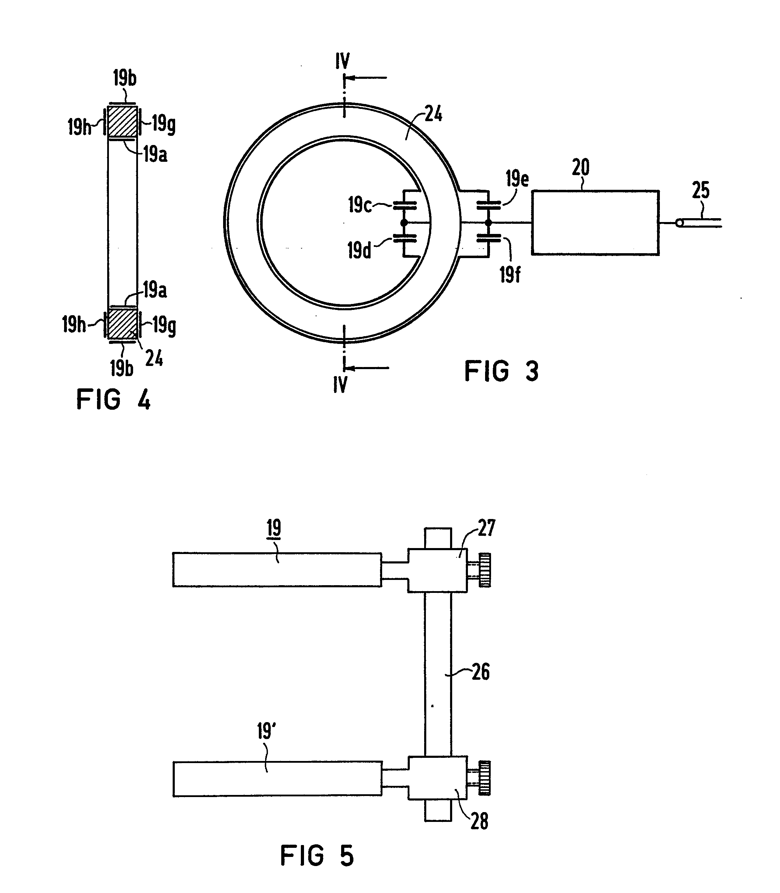

FIG 3 zeigt eine Anordnung, bei dem die Windungen 19a und 19b konstruktiv besonders einfach auf einem Ring 24 mit rechteckigem Querschnitt untergebracht sind. FIG 4 zeigt dieselbe Anordnung im Querschnitt. Dabei wird deutlich, daß man auf den Ring 24 zusätzlich zu den Windungen 19a und 19b noch zwei weitere Windungen 19g und 19h unterbringen kann. Die Windungen 19g und 19h werden ebenso wie die Windungen 19a und 19b an die Anpaßschaltung 20 angeschlossen, d.h. beide Windungen 19g und 19h über Kondensatoren an Massepotential und eine Windung mit direkt galvanischer Verbindung zum Signalanschluß der Anpaßschaltung. Die Anschlüsse für die Windungen 19g und 19h sind in FIG 3 der Übersichtlichkeit wegen nicht dargestellt.

Die Windungen 19g und 19h bilden einen zweiten Resonator, der durch unterschiedliche Dimensionierung der entsprechenden Kondensatoren auf eine von der Resonanzfrequenz des ersten Resonators (Windungen 19a und 19b) abweichende Resonanzfrequenz eingestellt werden kann. Damit ist mit dieser Anordnung die Untersuchung von Kernen mit unterschiedlicher Resonanzfrequenz möglich.

Die Windungen 19a,19b,19g,19h können am einfachsten aus einer auf den Träger 6 aufgeklebten Kupferfolie bestehen.

FIG 5 zeigt ein Ausführungsbeispiel, bei dem zwei Oberflächenresonatoren 19 und 19' in einer Helmholtzanordnung angeordnet sind. Die Oberflächenresonatoren 19 und 19' sind über Halter 27 bzw.28 an einem Stativ 26 verschiebbar angeordnet.

Zwischen den beiden Oberflächenresonatoren 19 und 19' entsteht damit ein homogenes Feld, in dem das Untersuchungsobjekt angeordnet werden kann.

Diese Helmholtzanordnung von zwei Oberflächenresonatoren 1 und 1' hat gegenüber einer Helmholtzanordnung mit Oberflächenspulen eine Reihe von Vorteilen. Das LC-Verhältnis des Oberflächenresonators ist günstiger als bei Oberflächenspulen, da die Induktivität L wegen der elektrischen Verkürzung durch die Kapazität C der Kondensatoren 1c-1f kleiner wird. Durch das günstigere LC-Verhältnis erhält man eine höhre Schwingkreis-Güte und ein besseres Signal-Rausch-Verhältnis. Durch Anordnung der Kupferfolien kann man die Feldverteilung besser steuern, als bei einer Oberflächenspule mit Draht. Aufgrund der Symmetrie treten praktisch keine Mantelwellen, d.h. durch Unsymmetrie entstehende Ströme auf dem Bezugsleiter 23 nach FIG 1 auf.

Wie bei den Loop gap-Resonatoren, die in der eingangs genannten Literaturstelle "Magnetic Resonance in Medicine 3, 590-603 (1986)" beschrieben sind, wären auch bei den erfindungsgemäßen Oberflächenresonatoren zwei Resonanzzustände bei unterschiedlichen Resonanzfrequenzen möglich, wenn die beiden Windungen 19a,19b bzw.19g,19h nicht miteinander verbunden wären. Dabei fließen in einem ersten Resonanzzustand, bei dem die magnetischen Feldlinien beide Windungen gleichförmig durchsetzen, die Ströme in beiden Windungen gleichsinnig. In einem zweiten Resonanzzustand, bei dem die magnetischen Feldlinien sich um jeweils eine Windung schließen, fließen die Ströme in beiden Windungen entgegengesetzt. Wenn man die beiden Windungen 19a und 19b bzw.19g und 19h über Kreuz miteinander verbindet, so wird der erste Resonanzzustand unterdrückt, so daß homogene Magnetfelder, die beide Windungen gleichförmig durchsetzen, nicht zu einer resultierenden Induktion führen. Somit reagiert ein solcher Oberflächenresonator nicht mehr auf Anregefelder, die beispielsweise von einem Körperresonator stammen, sondern nur noch auf Signale vom Untersuchungsobjekt, deren Feld immer inhomogen ist. Damit ist eine Entkopplung des Oberflächenresonators vom Körperresonator erreicht.

**Ansprüche**

1. Oberflächenresonator mit zwei benachbart angeordneten Windungen (19a,19b) für Kernspinresonanz-Geräte,
**dadurch gekennzeichnet,**
daß die Enden jeder Windung (19a,19b) über die Reihenschaltung von je zwei Kondensatoren (19c,19d;19e,19f) miteinander verbunden sind,
daß jeweils die Verbindungspunkte der Kondensatoren (19c,19d; 19e,19f) miteinander, die den elektrischen Symmetriepunkt jeder Windung (19a,19b) darstellen, mit Massepotential verbunden sind und daß Signalabgriff und Signaleinspeisung für den Oberflächenresonator galvanisch an den Enden einer Windung (19b) erfolgt.

2. Oberflächenresonator nach Anspruch 1,
**dadurch gekennzeichnet**
daß jede Windung (19a,19b) aus einem Band aus Kupferfolie besteht.

3. Oberflächenresonator nach Anspruch 1 oder 2,
**dadurch gekennzeichnet,**
daß ein Träger (24) aus einem zu einem Ring geformten Stab mit rechteckigem Querschnitt vorgesehen ist und daß die beiden Windungen (19a,19b) durch leitfähige Beläge auf zwei Seiten des Stabes (24) gebildet werden.

4. Oberflächenresonator nach Anspruch 3,
**dadurch gekennzeichnet,**
daß auf den Stab (24) auf vier Seiten Windungen (19a,19b;19g,19h) in Form von leitfähigen Belägen aufgebracht sind, daß je zwei Windungen (19a,19b;19g,19h) zu einem Resonator zusammengeschaltet sind und daß die so gebildeten beiden Resonatoren durch Einsatz von Kondensatoren (19c-19f) mit unterschiedlicher Kapazität unterschiedliche Resonanzfrequenzen aufweisen.

5. Anordnung mit einem Oberflächenresonator nach einem der Ansprüche 1 bis 4,
**dadurch gekennzeichnet,**

daß zwei derartige Oberflächenresonatoren (19,19') in Helmholtz-Anordnung so angeordnet sind, daß alle Windungsachsen auf einer Linie liegen.

87 P 3054

FIG 1

FIG 2

87 P 3054

FIG 4

FIG 3

FIG 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | EP-A-0 201 084 (MCW RESEARCH FOUNDATION INC.) * Seite 5, Zeile 36 - Seite 9, Zeile 5; Seite 12, Zeilen 21-24; Seite 24, Zeilen 1-31 * --- | 1,4 | G 01 N 24/04 |
| Y | EP-A-0 200 078 (SIEMENS AG) * Spalte 4, Zeile 38 - Spalte 6, Zeile 10; Figur 2 * --- | 1,2 | |
| A | DE-A-3 608 473 (ELSCINT LTD) * Seite 8, Zeile 4 - Seite 9, Zeile 18; Seite 12, Zeile 11 - Seite 13, Zeile 10; Figuren 2,5,6 * --- | 1,4 | |
| A,D | MAGNETIC RESONANCE IN MEDICINE, Band 3, 1986, Seiten 590-603, Academic Press, Inc., New York, US; W. FRONCISZ et al.: "Counter rotating current local coils for high-resolution magnetic resonance imaging" * Seiten 590-596 * --- | 1 | |
| | | | **RECHERCHIERTE SACHGEBIETE (Int. Cl.4)** |
| A | EP-A-0 191 180 (SIEMENS AG) * Seite 5, Zeile 1 - Seite 6, Zeile 8; Figuren 2,3 * --- | 1,5 | G 01 N |
| A | US-A-4 613 837 (J. BLASS et al.) * Spalte 3, Zeile 42 - Seite 6, Zeile 15; Figur 6 * ----- | 1 | |

Der vorliegende Recherchenbericht wurde für alle Patentansprüche erstellt

| Recherchenort | Abschlußdatum der Recherche | Prüfer |
|---|---|---|
| DEN HAAG | 06-06-1988 | HORAK G.I. |